# EUROPEAN PATENT SPECIFICATION

(11) **EP 1 962 325 B1**
(45) Date of publication and mention of the grant of the patent: **19.04.2017**
(21) Application number: 06833347.5
(22) Date of filing: 27.11.2006
(51) Int. Cl.: H01L 21/762

(54) **METHOD FOR MANUFACTURING BONDED SUBSTRATE**
VERFAHREN ZUR HERSTELLUNG EINES GEBONDETEN SUBSTRATS
PROCÉDÉ DE FABRICATION D'UN SUBSTRAT LIÉ

(30) Priority: 16.12.2005 JP 2005363317
(43) Date of publication of application: 27.08.2008
(73) Proprietor: Shin-Etsu Handotai Co., Ltd., Tokyo (JP)
(72) Inventor: MITANI, Kiyoshi, Gunma 379-0196 (JP)
(74) Representative: Wibbelmann, Jobst
(86) International application number: PCT/JP2006/323543
(87) International publication number: WO 2007/069442

(56) References cited:
- EP-A- 0 964 436
- EP-A- 0 971 396
- WO-A-2005/038903
- WO-A1-01/27999
- DE-A1- 10 234 979
- JP-A- 04 085 827
- JP-A- 11 045 862
- JP-A- 2005 123 263
- JP-A- 2005 123 263

## Description

### TECHNICAL FIELD

The present invention relates to a method for manufacturing a bonded substrate by bonding an active layer wafer to a support substrate wafer and then reducing a film thickness of the active layer wafer, e.g., a method for manufacturing a bonded substrate such as a directly bonded substrate or an SOI substrate.

### BACKGROUND ART

As a semiconductor substrate for a high-performance device, a bonded substrate obtained by bonding an active layer wafer to a support substrate wafer and then reducing a film thickness of the active layer wafer is used. As one of such bonded substrates, an SOI substrate is known.

As a method for manufacturing the SOI substrate, the following method is known, for example. That is, two mirror-polished silicon wafers (an active layer wafer and a support substrate wafer) are prepared, and an oxide film is formed on at least one of the wafers. These wafers are bonded to each other through the oxide film and then subjected to a heat treatment, thereby increasing bonding strength. Subsequently, a film thickness of the active layer wafer is reduced to obtain an SOI substrate having an SOI (Silicon on Insulator) layer formed thereon. As this film thickness reducing method, there are a method for, e.g., grinding or polishing the active layer wafer until a desired thickness is obtained, a method for delaminating the active layer wafer at an ion implanted layer based on a method called an ion implantation and delamination method, and others.

It is to be noted that, when manufacturing a bonded substrate, silicon wafers may be directly bonded to each other without interposing an oxide film therebetween. Further, an insulator wafer formed of, e.g., quartz, a silicon carbide, or alumina may be used as the support substrate wafer.

Meanwhile, when manufacturing a bonded substrate such as an SOI substrate as explained above, outer peripheral portions of two mirror-polished wafers to be bonded are subjected to R chamfering to avoid breakage, cracks, or particle generation, they also have a part called a polishing sag where a thickness is slightly small, and such a part remains as an unbonded portion that is not bonded at all or has a weak bonding force. When a film thickness of the active layer wafer is reduced by, e.g., grinding while such an unbonded portion remains, the unbonded portion is partially delaminated during this film thickness reducing process. Therefore, the active layer wafer subjected to film thickness reduction has a diameter smaller than that of the support substrate wafer, and small irregularities are continuously formed on a peripheral portion.

Furthermore, when such a bonded substrate is subjected to a device process, the remaining unbonded portion is delaminated in the device process, and particles are generated, thereby reducing a device yield.

To avoid this problem, the unbonded portion remaining in the outer peripheral portion of the active layer wafer must be previously removed before reducing a film thickness of the active layer wafer based on, e.g., grinding. (It is to be noted that a portion where the support substrate wafer is exposed by removing the unbonded portion in this manner is called a terrace portion.)

Therefore, several methods for previously removing the unbonded portion remaining in the outer peripheral portion of the active layer wafer have been conventionally proposed. For example, Japanese Patent Application Laid-open No. 1986-256621 discloses a method for bonding two wafers to each other and then chamfering an entire peripheral portion of an SOI substrate. Moreover, Japanese Patent Application Laid-open No. 1989-227441 discloses a method for grinding an active layer wafer in a bonded SOI layer to a predetermined thickness and then grinding a peripheral portion of this wafer and a part of a bonding surface side of the other base wafer. Additionally, Japanese Patent Application Laid-open No. 1992-85827 and Japanese Patent Application laid-open No. 1998-270298 disclose a method for previously grinding a peripheral portion of an active layer wafer for a predetermined thickness from a bonding surface before bonding the active layer wafer to a support substrate wafer, bonding these wafers to each other, and then performing grinding from an opposite surface of the bonding surface so that the remaining peripheral portion of this active layer wafer can be all ground down to provide a predetermined thickness as a whole.

Further, as a method for manufacturing a thin-film SOI substrate mainly having a film thickness of substantially 2 µm, there is known a method called the ion implantation and delamination method. According to this method, a hydrogen ion or a rare gas ion is implanted into an active layer wafer, this wafer is bonded to a support substrate wafer, and then the active layer wafer is delaminated at an ion implanted surface based on a heat treatment (see Japanese Patent Application Laid-open No. 1993-211128).

However, the above-explained methods have the following inconveniences. That is, in the method disclosed in Japanese Patent Application Laid-open No. 1986-256621, there occurs a problem that a diameter of the entire bonded substrate becomes small and existing facilities and jigs cannot be used as they are. Furthermore, Japanese Patent Application Laid-open No. 1989-227441 has a problem that etching must be carried out and the number of processes is increased since a damaged layer is produced due to grinding and that a wafer shape varies since grinding is carried out until reaching a portion near a periphery of the support substrate wafer. Moreover, Japanese Patent Application Laid-open No. 1992-85827 has a problem that a protrusion and others are generated on a ground surface depending on a state of a grinding stone, resulting in a factor of particle generation (see also JP 2005 123263 A, SHINKO ELECTRIC IND CO, 12 May 2005). Further, Japanese Patent Application Laid-open No. 1998-270298 has a problem that etching must be further carried out to suppress production of, e.g., a protrusion on this ground surface and the number of processes is increased. Additionally, Japanese Patent Application Laid-open No. 1993-211128 has a problem that a shape of an edge portion of an active layer is not managed and irregularities and others remain since an unbonded portion must remain in an outer peripheral portion because of, e.g., a polishing sag at the peripheral portion of a wafer.

### DISCLOSURE OF INVENTION

In view of the above-explained problems, it is an object of the present invention to provide a method for manufacturing a bonded substrate, the method enabling simplifying processes, avoiding breakage, cracks, or particle generation, and accurately managing a shape of an edge portion of an active layer wafer when reducing a film thickness of the active layer wafer.

To achieve this object, according to the present invention, there is provided a method for manufacturing a bonded substrate where an active layer wafer is bonded to a support substrate wafer, comprising:
a first step of providing a groove on an inner side on a surface of the active layer wafer along an outer peripheral portion over an entire circumference;
a second step of determining a surface where the groove is formed as a bonding surface and bonding the active layer wafer to the support substrate wafer; and
a third step of reducing a film thickness of the active layer wafer and removing an unbonded portion on an outer side of the groove of the active layer wafer, characterized in that the groove provided on the inner side on the surface of the active layer wafer along the outer peripheral portion is machined by using a water jet guided laser.

As explained above, in the present invention, the groove is provided on the active layer wafer in advance at the first step, then the active layer wafer is bonded to the support substrate wafer at the second step, and a film thickness reduction is carried out at the third step. Previously providing the groove on the active layer wafer eliminates a necessity for grinding after the active layer wafer is bonded to the support substrate wafer and thereby eliminates a need for etching, and hence the processing steps are simplified and generation of, e.g., a protrusion at the time of grinding can be suppressed. Further, the peripheral shape of the active layer subjected to the film thickness reduction becomes excellent, a possibility of particle generation can be lowered, and the terrace portion can be narrowed.

Furthermore, in the method for manufacturing a bonded substrate according to the present invention, the reduction in a film thickness of the active layer wafer can be carried out by grinding a back surface of the active layer wafer until reaching a groove portion from the surface.

In case of reducing the film thickness based on grinding in this manner, using the above-explained step enables suppressing breakage, cracks, or particle generation in the active layer wafer outer peripheral portion at the time of film thickness reduction, thereby manufacturing the bonded substrate having the thick active layer with an excellent peripheral shape without a need for adding an etching step that is required when the outer periphery is ground.

Moreover, in the method for manufacturing a bonded substrate according to the present invention, the reduction in a film thickness of the active layer wafer can be carried out by previously providing an ion implanted layer at a depth that does not exceed the groove portion from the bonding surface of the active layer wafer based on ion implantation before the first step or the second step and delaminating the active layer wafer at the ion implanted layer based on a delamination heat treatment at the third step.

In case of reducing the film thickness based on the ion implantation and delamination method in this manner, using the above-explained step enables defining a shape of the edge portion by a shape of the groove when the active layer wafer is delaminated. Therefore, the shape of the outer peripheral edge portion of the active layer in the bonded substrate can be managed based on the ion implantation and delamination method, the excellent shape can be provided, and particle generation can hardly occur. In particular, this is preferable when providing the active layer having a small film thickness.

Additionally, in the method for manufacturing a bonded substrate according to the present invention, bonding of the active layer wafer and the support substrate wafer can be performed through an oxide film formed on one of the surfaces or both the surfaces.

In recent years, a bonded substrate such as an SOI substrate obtained by bonding semiconductor single crystal wafers through an oxide film attracts attention, and its quality requirements are becoming more severe. According to the method for manufacturing a bonded substrate of the present invention, a bonded SOI substrate having a high-quality oxide film interposed therein that can satisfy severe quality requirements concerning a shape of an outer peripheral portion can be manufactured.

Further, in the method for manufacturing a bonded substrate according to the present invention, the groove provided on the inner side on the surface of the active layer wafer along the outer peripheral portion is machined by using a water jet guided laser.

When the groove is machined by using the water jet guided laser in this manner, a rise that is produced when using a laser beam to effect machining can be avoided. Furthermore, the groove having a desired depth can be readily formed. Therefore, subsequent bonding becomes excellent, and an unbonded portion at the periphery can be assuredly removed.

It is to be noted that the water jet guided laser performs machining in such a manner that total reflection is utilized to confine a laser beam to a water column pushed out at a high pressure.

Furthermore, in the method for manufacturing a bonded substrate according to the present invention, it is preferable that the groove provided on the inner side on the surface of the active layer wafer along the outer peripheral portion is provided at a position that is 1 to 2 mm apart from the outer peripheral portion.

With such an arrangement, when the wafers are superposed, a portion outside the groove becomes a portion that is not closely contacted by, e.g., a polishing sag of the wafers, i.e., a portion that is not bonded even though a subsequent bonding heat treatment is carried out, thereby facilitating removal of the outer side of the groove after bonding the wafers and assuredly and firmly bonding an inner region of the groove.

Moreover, in the method for manufacturing a bonded substrate according to the present invention, the groove provided on the inner side on the surface of the active layer wafer along the outer peripheral portion is provided before mirror-polishing the active layer wafer, and mirror polishing of the active layer wafer can be performed after the groove is provided.

With such an arrangement, even if a rise is produced when the groove is machined, the rise can be removed by mirror polishing, thus assuring excellent bonding.

Additionally, in the method for manufacturing a bonded substrate according to the present invention, the groove provided on the inner side on the surface of the active layer wafer along the outer peripheral portion can be provided after mirror-polishing the active layer wafer.

As explained above, in the method for manufacturing a bonded substrate according to the present invention, even if the groove is provided after mirror polishing, the unbonded portion in the active layer wafer outer peripheral portion can be removed. In particular, when forming the oxide film on the surface of the active layer wafer, forming the groove after formation of the oxide film following mirror polishing is preferable.

As explained above, according to the present invention, the operation of removing the unbonded portion when reducing the film thickness of the bonded substrate is carried out by previously forming the groove on the active layer wafer before bonding the active layer wafer to the support substrate wafer. Therefore, the simple processes can provide the bonded substrate in which a diameter thereof after bonding does not vary, breakage, cracks, or particle generation does not occur from the ground surface of the edge portion, and the shape of the edge portion is excellent.

### BRIEF DESCRIPTION OF DRAWINGS

FIG. 1 is a flow sheet showing a method for manufacturing a bonded substrate according to the present invention, which corresponds to an example where a film thickness is reduced based on surface grinding;
FIG. 2 is a schematic block diagram showing how to form a groove according to the present invention;
FIG. 3 is a flow sheet showing the method for manufacturing a bonded substrate according to the present invention, which corresponds to an example where a film thickness is reduced based on an ion implantation and delamination method;
FIG. 4 is a schematic view showing a water jet guided laser;
FIG. 5 is a flow sheet showing a conventional method for removing an unbonded portion in an active layer wafer outer peripheral portion; and
FIG. 6 is a flow sheet showing another conventional method for removing an unbonded portion in an active layer wafer outer peripheral portion.

### BEST MODE(S) FOR CARRYING OUT THE INVENTION

The present invention will now be explained hereinafter in more detail.

The present inventor has conducted examinations and studies to discover a method for manufacturing a bonded substrate in which breakage, cracks, or particle generation does not occur in an outer peripheral portion of an active layer wafer including an unbonded portion and an outer peripheral shape thereof is excellent without complicating processes.

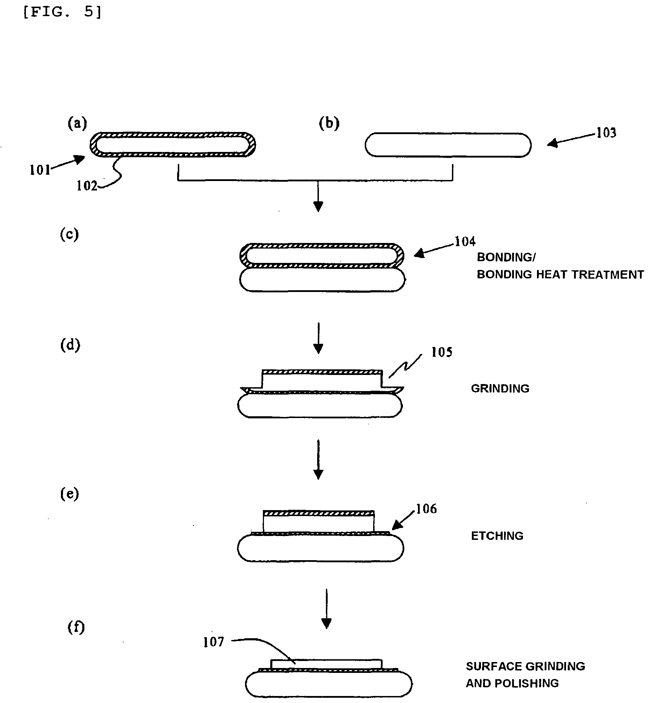

In a conventional method, an unbonded portion in a wafer peripheral portion is removed after an active layer wafer is bonded to a support substrate wafer as explained below. That is, for example, as shown in FIG. 5, an active layer wafer 101 having an oxide film 102 formed thereon and a support substrate wafer 103 are prepared (a, b) and bonded to each other to provide a bonded substrate 104 (c), and then the active layer wafer side is ground to form an ground portion 105 (d). Further, the outer peripheral portion is etched until reaching the support substrate wafer, thereby forming a terrace portion 106 (e). Subsequently, the active layer wafer is ground and polished until a desired thickness is obtained, thus providing a bonded substrate having an active layer 107 (f).

However, this method has a problem that an etching step and a surface grinding step are required after grinding as explained above, thereby complicating processes.

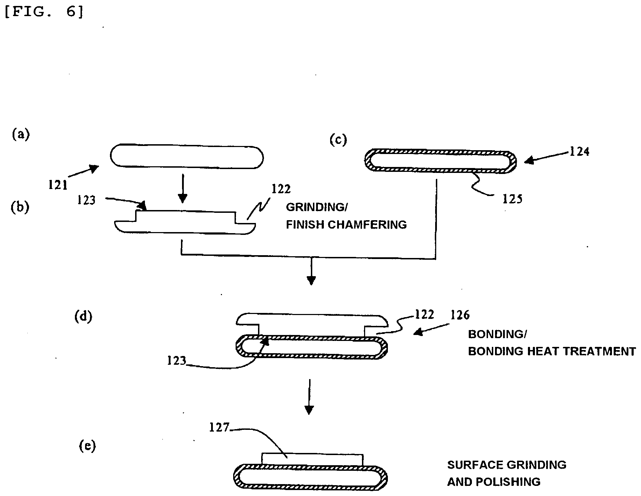

Furthermore, in an improved method disclosed in Japanese Patent Application Laid-open No. 1998-270298, as shown in FIG. 6, an active layer wafer 121 and a support substrate wafer 124 having an oxide film 125 formed thereon are prepared (a, c). The active layer wafer is ground to form a ground portion 122 before bonding both the wafers (b). The ground surface 123 is determined as a bonding surface, both the wafers are bonded to each other to provide a bonded substrate 126 (d), and then grinding and polishing are carried out until a desired thickness is obtained, thus providing the bonded substrate having an active layer 127(e).

However, this method still has a problem that finish chamfering is required after grinding since a damaged layer remains, which results in complicated processes.

Thus, the present inventor has paid attention to a difference in bonding force between a wafer central portion and an unbonded portion when the active layer wafer is bonded to the support substrate wafer as a result of keenly repeating examinations. That is, the present inventor has conceived that previously providing a groove on the active layer wafer before bonding enables separating the wafer central portion from the unbonded portion as a method for keeping the wafer central portion where strong bonding can be achieved, removing the unbonded portion in the active layer wafer outer peripheral portion, and also managing an edge shape of the active layer wafer, thereby bringing the present invention to completion.

That is, the method for manufacturing a bonded substrate according to the present invention that is a method for manufacturing a bonded substrate in which an active layer wafer is bonded to a support substrate wafer is characterized by comprising: a first step of providing a groove on an inner side on a surface of the active layer wafer along an outer peripheral portion over an entire circumference; a second step of determining the surface having the groove provided thereon as a bonding surface and bonding the active layer wafer to the support substrate wafer; and a third step of reducing a film thickness of the active layer wafer and removing an unbonded portion on an outer side of the groove on the active layer wafer.

Although such a method for manufacturing a bonded substrate according to the present invention will be further specifically explained hereinafter with reference to the accompanying drawings, the present invention is not restricted thereto.

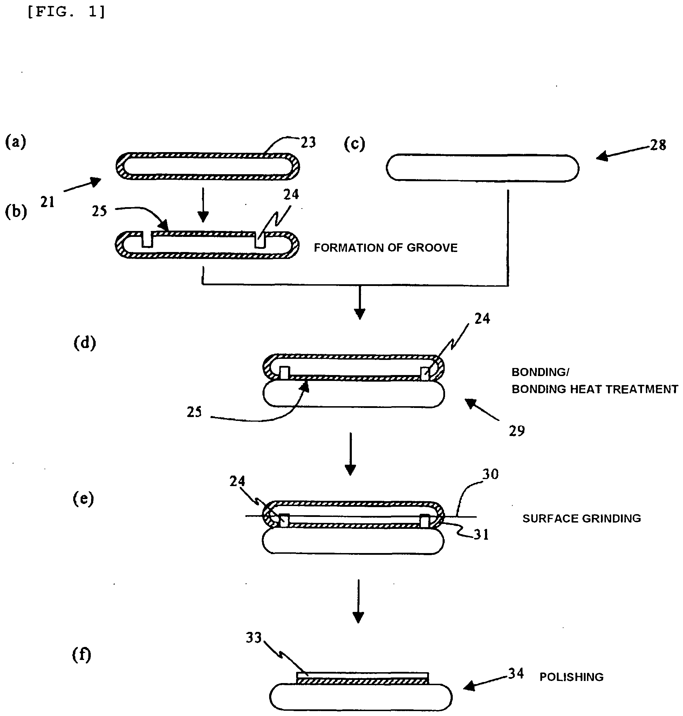

FIG. 1 is a flow sheet showing a method for manufacturing a bonded substrate by removing an unbonded portion in an outer peripheral portion of an active layer wafer based on the method according to the present invention, which is a method for reducing a film thickness based on surface grinding.

FIG. 1(a) shows an active layer wafer 21 having an oxide film 23 formed thereon. The oxide layer 23 may be formed on the active layer wafer, may be formed on a support substrate wafer, or may be formed on both the wafers. When directly bonding two wafers, this oxide film is not formed.

Then, as shown in FIG. 1(b), a groove 24 is formed on the active layer wafer 21 along an outer periphery thereof.

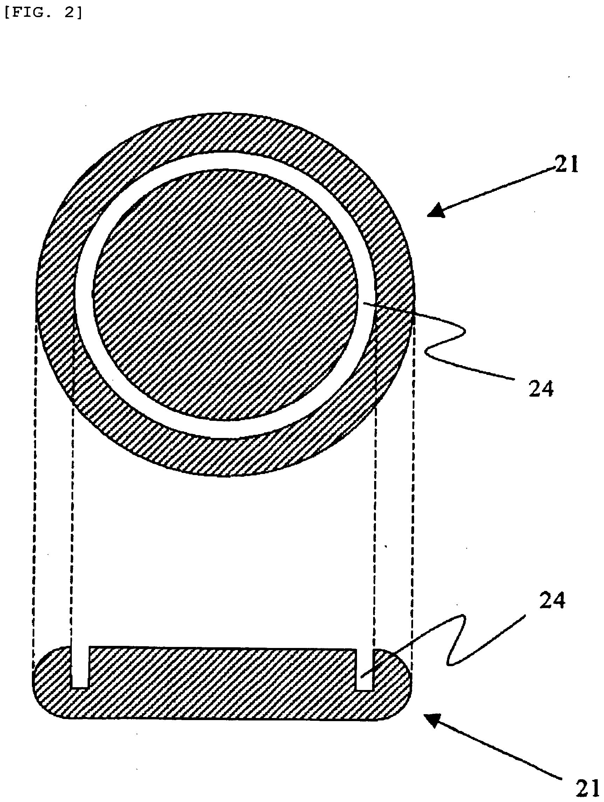

FIG. 2 schematically shows an example of a groove formed on the active layer wafer based on the method according to the present invention. The groove 24 is formed on an inner side on a surface of the active layer wafer 21 along the outer peripheral portion over an entire circumference.

For example, a groove having a groove width of 100 µm and a groove depth of 50 to 100 µm is formed in a region that is 1.5 to 2 mm apart from the wafer outer peripheral portion on the inner side along the outer periphery. When an orientation flat is provided, the groove is likewise formed in this region on the inner side along its shape. Although these numerical values are not restricted in particular, adopting these values enables a portion outside the groove to become a portion that is not closely contacted even though, e.g., a polishing sag of the wafer occurs, i.e., a portion that is not bonded even though a subsequent heat treatment is performed when the wafers are superposed, thereby facilitating removal of the outer side of the groove after wafer bonding and assuredly firmly bonding the inner region of the groove.

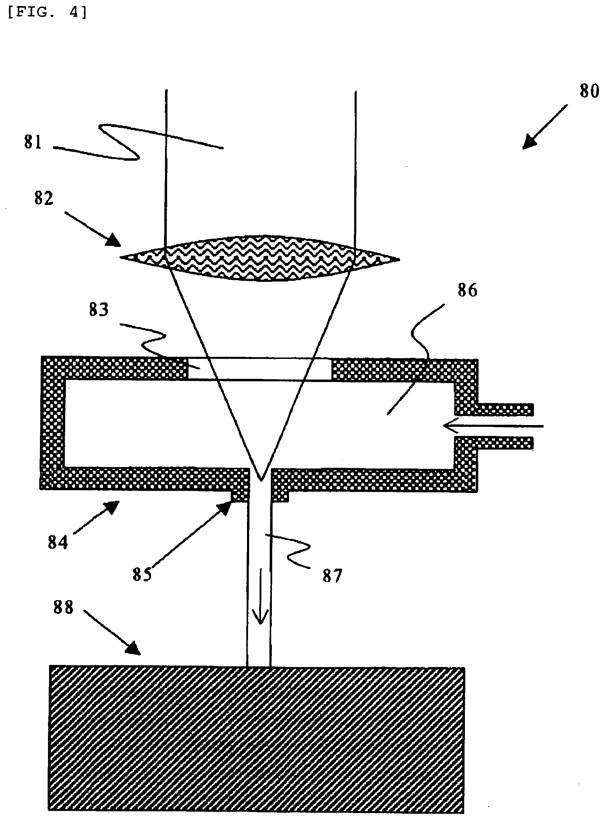

Such a groove 24 is formed by a water jet guided laser device 80 shown in FIG. 4 to form the groove.

This water jet guided laser device 80 includes a window 83 transparent to a laser beam 81 and a water chamber 84 filled with high-pressure water 86. A water guide 87 emitted from a nozzle 85 reaches a workpiece 88 while maintaining a fixed diameter. The laser beam 81 condensed at a position near the nozzle 85 by a condenser lens 82 does not exit the water guide 87 since total reflection is repeated in the water guide 87, and reaches the workpiece 88 to process the workpiece 88.

In this manner, when the groove is processed by the water jet guided laser, a rise caused at the time of processing using the laser beam can be avoided. Further, the groove with a desired depth can be easily formed. Therefore, subsequent bonding becomes excellent, and an unbonded portion at the periphery can be assuredly removed. Furthermore, since the processed portion hardly has a high temperature and a rise is rarely produced, bonding can be facilitated even though the groove is formed.

Moreover, such a groove 24 may be formed before primary mirror polishing or after primary mirror polishing for the active layer wafer 21. When the groove is formed before the primary mirror polishing, i.e., before mirror polishing or after the primary mirror polishing, i.e., before finish polishing, even if a rise and others are produced due to formation of the groove, they can be removed because a polishing step, e.g., subsequent finish polishing is present, thus assuring excellent bonding.

Additionally, the groove 24 may be provided after the active layer wafer 21 is subjected to mirror polishing. Even if the groove is provided after mirror polishing in this manner, the unbonded portion in the active layer wafer outer peripheral portion can be removed.

Further, the groove 24 may be formed after the oxide film 23 is formed as explained above, or the groove may be formed before the oxide film is formed. As the groove depth, 35 to 40 µm can suffice in case of an SOI wafer in which a total thickness of an active layer and a buried oxide film layer is 20 µm, for example.

Then, as shown in FIG. 1(d), the active layer wafer 21 depicted in FIG. 1(b) is bonded to a support substrate wafer 28 shown in (c) to provide a bonded substrate 29, and then a bonding heat treatment is carried out.

At this time, in regard to bonding the active layer wafer to the support substrate wafer, a surface 25 where the groove 24 is formed is brought into contact with one of main surfaces of the support substrate wafer 28 in a clean atmosphere at a normal temperature, thereby bonding the wafers to each other without using, e.g., an adhesive. The subsequent bonding heat treatment can be carried out in, e.g., an inert gas atmosphere or an oxidizing atmosphere at 1000 to 1200°C in the range of 30 minutes to 2 hours.

As a result, a bonding force can be increased to enable resistance against subsequent grinding.

Then, as shown in FIG. 1(e), the bonded substrate 29 is subjected to surface grinding from the active layer side until reaching a plane 30, i.e., the groove 24. At this time, an outer edge portion 31 on the active layer wafer side is simultaneously removed.

For example, grinding is carried out in such a manner that a final active layer thickness becomes +10 to 30 µm. When grinding is performed in this manner, the groove 24 appears after grinding, but deeply forming the groove can suffice when fabricating the bonded substrate having a large active layer thickness.

At this time, the outer edge portion 31 on the outer peripheral side of the groove 24 has a weak bonding force since the wafers are not uniformly bonded due to, e.g., a polishing sag at the time of wafer bonding, the outer edge portion 31 as a region on the outer side of the groove is removed by grinding, and a region on the inner side of the groove alone remains.

Then, as shown in FIG. 1(f), performing polishing until a desired active layer thickness is obtained enables finally manufacturing a bonded substrate 34 having an active layer 33.

For example, polishing is performed until the active layer thickness becomes 20 µm, and mirror finishing is simultaneously carried out.

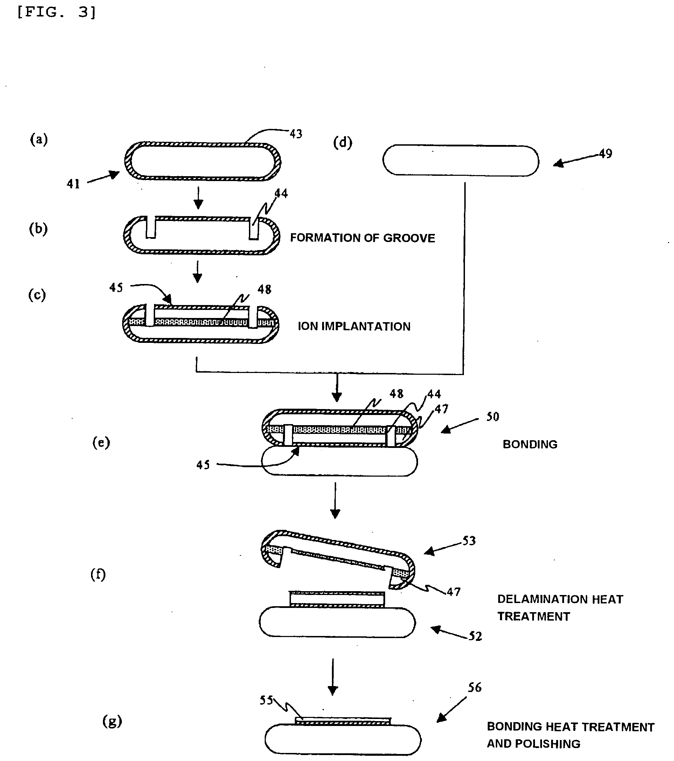

Next, FIG. 3 is a flow sheet showing another method for manufacturing a bonded substrate according to the present invention, which is a method for reducing a film thickness based on an ion implantation and delamination method.

FIG. 3(a) shows an active layer wafer 41 having an oxide film 43 formed thereon. The oxide film 43 may be formed on the active layer wafer, may be formed on a support substrate wafer, may be formed on both the wafers, or may not be formed when directly bonding the wafers to each other.

Then, as shown in FIG. 3(b), a groove 44 is formed on the active layer wafer 41 along an outer periphery.

Such a groove is formed by using the water jet guided laser device 80 depicted in FIG. 4.

For example, a groove having a groove width of 100 µm and a groove depth of 15 to 20 µm is formed in a region on the inner side that is 1 to 2 mm apart from a wafer outer peripheral portion along the outer periphery. These values are not restricted in particular.

It is to be noted that such a groove may be formed after the oxide film is formed or the groove may be formed before the oxide film is formed. Further, the groove may be formed before primary mirror polishing of the wafer, may be formed after the primary mirror polishing, or may be formed after laser-explained ion implantation. When the groove is formed before the primary mirror polishing, i.e., before mirror polishing or after the primary mirror polishing, i.e., before finish polishing, since a subsequent polishing step, e.g., finish polishing is present, even if a rise and others are produced due to formation of the groove, they can be removed. Furthermore, when the groove is formed after mirror polishing, a groove depth of 2 to 10 µm can suffice.

Subsequently, as shown in FIG. 3(c), an ion is implanted into the active layer wafer 41 from a surface 45 side where the groove 44 is formed, thereby forming an ion implanted layer 48. The ion implanted at this step is at least one of a hydrogen ion and a rare gas ion.

At this time, although forming an oxide film on an implantation surface of the active layer wafer to avoid channel is preferable, it does not have to be necessarily formed. It is to be noted that a depth of the ion implanted layer 48 is reflected in a thickness of a finally formed active layer 55. Therefore, controlling, e.g., an implantation energy to implant the ion enables controlling the thickness of the active layer. That is, the depth of the ion implanted layer is equal to or above a desired thickness of the active layer and smaller than the depth of the groove 44.

Then, as shown in FIG. 3(e), the active layer wafer 41 depicted in FIG. 3(c) is bonded to and a support substrate wafer 49 shown in FIG. 3(d) with the surface 45 where the groove is formed being determined as a bonding surface, thereby providing a bonded substrate 50.

At this time, in regard to bonding of the active layer wafer and the support substrate wafer, when the surface 45 where the groove 44 is formed is brought into contact with one of main surfaces of the support substrate wafer 49 in, e.g., a clean atmosphere at a normal temperature, and the wafers are bonded to each other without using, e.g., an adhesive, thereby obtaining the bonded substrate 50.

Subsequently, as shown in FIG. 3(f), a delamination heat treatment is carried out, a major part 53 of the active layer wafer is delaminated from a bonded substrate 52 at the ion implanted layer 48. At this time, since a bonding force of both the wafers on the outer peripheral portion is weaker than a bonding force of the inner side apart from the groove, an unbonded portion 47 on the active layer side remains bonded to the major part 53 of the delaminated active layer wafer.

As this delamination heat treatment, when a heat treatment is performed with respect to the bonded substrate 50 in an inert gas atmosphere at a temperature of 300 to 600°C, rearrangement of a crystal and agglomeration of air bubbles can be utilized to delaminate the active layer wafer 41 at the ion implanted layer 48.

At this time, since bonding strength of the outer peripheral portion from the region where the groove is formed is small, the active layer is not transferred to the support substrate wafer. Furthermore, in the wafer in a region on the inner side apart from the region where the groove is formed, transference is completely carried out. That is, a transference region of the active layer is defined by the previously formed groove, and an edge portion of the active layer is finely uniformed. A position of the edge portion of the delaminated active layer that is 1 to 2 mm apart from the outer periphery is a region where a polishing sag starts and has low bonding strength, but its adjacent portion, e.g., a region of the edge portion that is 3 to 4 mm apart from the outer periphery is strongly bonded with the support substrate wafer and subjected to transference, and hence transference occurs due to rigidity of the wafer itself. On the other hand, when the groove is not formed, bonding does not occur at a position of the active layer wafer that is 1 mm apart from the outer periphery before delamination, a region of the active layer wafer that is 1 to 2 mm apart from the outer periphery includes portions pulled by behaviors on the inner side and the outer side, and the edge portion of the delaminated active layer is not finely uniformed. That is, when the groove is formed, the region on the inner side apart from the groove is not affected by the region that is 1 mm from the outermost periphery, the active layer can be consequently transferred and formed to the outer side, and the edge portion can have an excellent shape. Therefore, particle generation hardly occurs, and the active layer can be expanded.

Then, as shown in FIG. 3(g), after performing a bonding heat treatment, polishing is carried out until a desired active layer thickness and a desired surface flatness degree can be obtained, thereby finally manufacturing a bonded substrate 56 having an active layer 55.

The bonding heat treatment at this step is carried out at a temperature higher than that of the delamination heat treatment. For example, this treatment can be performed in an inert gas atmosphere or an oxidizing atmosphere at 1000 to 1200°C in the range of 30 minutes to 2 hours. It is to be noted that this bonding heat treatment can also serve as the delamination heat treatment.

Moreover, polishing at this step can be carried out based on touch polishing with a stock removal of 100 nm or below, and the surface is mirror-finished. The method for obtaining a desired active layer thickness after delamination is not restricted to polishing explained above, and so-called sacrificial oxidation for removing an oxide film generated after an oxidizing heat treatment based on etching may be performed, for example.

Although the present invention will now be more specifically explained based on examples according to the present invention, the present invention is not restricted thereto.

### (Example 1)

A description will be first given on a method for reducing a film thickness of an active layer wafer based on surface grinding after the active layer wafer is bonded to a support substrate wafer.

A p-type <100> single crystal silicon ingot having a resistance of 8 to 12 Ωcm pulled up by a Czochralski method was sliced to obtain a thin discoid wafer having a diameter of 150 mm (6 inches) and a thickness of 625 µm. An outer edge portion was chamfered to avoid breakage, cracks, and particle generation in the wafer, and then lapping was carried out to flatten the wafer. Subsequently etching was performed to remove a mechanical damage remaining on a surface of the lapped wafer. Further, primary mirror polishing was performed with respect to both front and back surfaces of the wafer, and a chamfer portion was also polished.

As explained above, the silicon wafer was subjected to primary mirror polishing, thereby providing an active layer wafer. A water jet guided laser was used with respect to this wafer to form a groove having a groove width of 100 µm and a groove depth of 100 µm in a region on the inner side that is 1.5 mm apart from an outer periphery of the wafer surface along the outer periphery as shown in FIG. 2. As a condition of the water jet guided laser at this step, a long-cycle pulse having a wavelength of 1064 nm was used. After forming the groove, mirror finishing was carried out.

Then, this wafer was subjected to a heat treatment in an oxidizing atmosphere to form an oxide film on the entire surface of the wafer. Furthermore, an additionally prepared support substrate wafer subjected to finish mirror polishing after the primary mirror polishing was brought into contact with a side where the groove of the active layer wafer is formed, these wafers were bonded to each other by applying a pressure, and a bonding heat treatment was performed in an Ar atmosphere at 1100°C for 2 hours.

The entire active layer wafer side of the thus obtained bonded SOI substrate was ground to be flattened until a SOI thickness of approximately 30 µm was obtained.

Then, usual polishing was done to fabricate a bonded substrate having an SOI layer with a thickness of 20 µm as shown in FIG. 1(f).

Microscopically observing an outer peripheral edge portion and a terrace portion of an active layer in the thus obtained SOI wafer, an excellent shape was obtained, and a so-called SOI island where an SOI layer is isolated like an island was not observed at all. Moreover, since just the groove was formed, processes were simple. A region of the terrace portion was provided at a position that is 1.5 mm apart from the outer periphery, and an active layer region was expanded as compared with a structure where the region of the terrace portion is provided at a position that is approximately 3 mm apart from the outer periphery according to a conventional method for reducing a film thickness based on grinding.

### (Example 2)

A description will now be given as to a method for reducing a film thickness of an active layer wafer after bonding the active layer wafer to a support substrate wafer based on an ion implantation and delamination method.

First, like Example 1, the silicon wafer was subjected to primary mirror polishing to provide an active layer wafer. A water jet guided laser was used with respect to this wafer to form a groove having a groove width of 100 µm and a groove depth of 10 µm in a region of a wafer periphery that is 1 mm apart from an outer periphery long the outer periphery as shown in FIG. 2. As a condition of the water jet guided laser at this step, a long-cycle pulse having a wavelength of 1064 nm was used. After forming the groove, mirror finishing was effected.

Subsequently, this active layer wafer was subjected to a heat treatment in an oxidizing atmosphere to form an oxide film on an entire surface of the wafer. This active layer wafer was subjected to hydrogen ion implantation under conditions of 10×10¹⁶/cm² as a dose amount and 1 µm as an implantation depth.

Moreover, an additionally prepared support substrate wafer subjected to the finish mirror polishing was brought into contact with and bonded to one side of the active layer wafer where the groove was formed. Then, a temperature was increased to 500°C in an Ar atmosphere to carry out a delamination heat treatment. At this time, an unbonded portion on the active layer wafer side was removed while being bonded to the active layer wafer.

Subsequently, a bonding heat treatment was done in an Ar atmosphere at 1100°C for 2 hours.

Then, so-called touch polishing with a small stock removal was performed, thereby fabricating a bonded substrate having an SOI layer with a thickness of 0.5 µm as shown in FIG. 3(g).

Microscopically observing an outer peripheral edge portion and a terrace portion of an active layer in the thus obtained SOI wafer, an excellent shape was provided, and an SOI island was not observed at all. Additionally, since just the groove was formed, processes were simple. A region of the terrace portion was provided at a position that is 1 mm apart from the outer periphery, and an active layer region was expanded as compared with a structure where a region of the terrace portion is provided at a position that is 2 to 2.5 mm apart from the outer periphery according to a conventional method for reducing a film thickness based on an ion implantation and delamination method.

It is to be noted that the present invention is not restricted to the foregoing examples. The examples are just exemplifications, and any examples that have substantially the same structures as those in technical concepts explained in claims according to the present invention and demonstrate the same functions and effects are included in the technical scope of the present invention.

For instance, although the case where the two semiconductor substrates, especially silicon wafers are bonded to fabricate the bonded substrate has been mainly explained in the examples, the present invention is effective for removal of a peripheral unbonded portion since this portion is likewise produced when bonding a semiconductor substrate to an insulator substrate consisting of, e.g., a quartz, a silicon carbide, a silicon nitride, an alumina, sapphire, or any other ceramics material to fabricate a bonded substrate.

Additionally, when the water jet guided laser is used to form the groove, even if a material is other than silicon, appropriately selecting a wavelength of the laser enables processing similar to that for silicon.

## Claims

1. A method for manufacturing a bonded substrate where an active layer wafer is bonded to a support substrate wafer, comprising:
a first step of providing a groove on an inner side on a surface of the active layer wafer along an outer peripheral portion over an entire circumference;
a second step of determining a surface where the groove is formed as a bonding surface and bonding the active layer wafer to the support substrate wafer; and
a third step of reducing a film thickness of the active layer wafer and removing an unbonded portion on an outer side of the groove of the active layer wafer, **characterized in that** the groove provided on the inner side on the surface of the active layer wafer along the outer peripheral portion is machined by using a water jet guided laser.

2. The method for manufacturing a bonded substrate according to claim 1, wherein the reduction in a film thickness of the active layer wafer is carried out by grinding a back surface of the active layer wafer until reaching a groove portion from the surface.

3. The method for manufacturing a bonded substrate according to claim 1, wherein the reduction in a film thickness of the active layer wafer is carried out by previously providing an ion implanted layer at a depth that does not exceed the groove portion from the bonding surface of the active layer wafer based on ion implantation before the first step or the second step and delaminating the active layer wafer at the ion implanted layer based on a delamination heat treatment at the third step.

4. The method for manufacturing a bonded substrate according to any one of claims 1 to 3, wherein bonding of the active layer wafer and the support substrate wafer is performed through an oxide film formed on one of the surfaces or both the surfaces.

5. The method for manufacturing a bonded substrate according to any one of claims 1 to 4, wherein the groove provided on the inner side on the surface of the active layer wafer along the outer peripheral portion is provided at a position that is 1 to 2 mm apart from the outer peripheral portion.

6. The method for manufacturing a bonded substrate according to any one of claims 1 to 5, wherein the groove provided on the inner side on the surface of the active layer wafer along the outer peripheral portion is provided before mirror-polishing the active layer wafer, and mirror polishing of the active layer wafer is performed after the groove is provided.

7. The method for manufacturing a bonded substrate according to any one of claims 1 to 5, wherein the groove provided on the inner side on the surface of the active layer wafer along the outer peripheral portion is provided after mirror-polishing the active layer wafer.

## Patentansprüche

1. Verfahren für die Herstellung eines gebondeten Substrats, wobei ein Aktive-Schicht-Wafer mit einem Träger-Substrat-Wafer gebondet wird, umfassend:
einen ersten Schritt des Bereitstellens einer Aussparung auf einer inneren Seite einer Oberfläche des Aktive-Schicht-Wafers entlang eines äußeren peripheren Abschnitts über einen gesamten Umfang;
einen zweiten Schritt des Bestimmens einer Oberfläche, an der die Aussparung gebildet wird als eine bondende Oberfläche und Bonden des Aktive-Schicht-Wafers mit dem Träger-Substrat-Wafer; und
einen dritten Schritt des Reduzierens einer Film-Dicke des Aktive-Schicht-Wafers und Entfernen eines ungebondeten Abschnitts auf einer äußeren Seite der Aussparung des Aktive-Schicht-Wafers, **dadurch gekennzeichnet, dass** die Aussparung auf der inneren Seite auf der Oberfläche des Aktive-Schicht-Wafers entlang des äußeren peripheren Abschnitts unter Verwendung eines wasserstrahlgeführten Lasers gefräst wird.

2. Verfahren für die Herstellung eines gebondeten Substrats nach Anspruch 1, wobei die Reduktion einer Film-Dicke des Aktive-Schicht-Wafers durch Schleifen einer Rückseite des Aktive-Schicht-Wafers durchgeführt wird, bis ein Aussparungs-Abschnitt von der Oberfläche erreicht wird.

3. Verfahren für die Herstellung eines gebondeten Substrats nach Anspruch 1, wobei die Reduktion einer Film-Dicke des Aktive-Schicht-Wafers durchgeführt wird durch vorheriges Bereitstellen einer ionenimplantierten Schicht in einer Tiefe, welche nicht den Aussparungs-Abschnitt von der Bonding-Oberfläche des Aktive-Schicht-Wafers überschreitet, basierend auf Ionenimplantation vor dem ersten Schritt oder dem zweiten Schritt und Delaminieren des Aktive-Schicht-Wafers an der ionenimplantierten Schicht, basierend auf einer Delaminierungs-Hitzebehandlung während dem dritten Schritt.

4. Verfahren für die Herstellung eines gebondeten Substrats nach einem beliebigen der Ansprüche 1 bis 3, wobei Bonden des Aktive-Schicht-Wafers und des Träger-Substrat-Wafers durch einen Oxidfilm durchgeführt wird, der auf einer der Oberflächen oder beiden Oberflächen gebildet wird.

5. Verfahren für die Herstellung eines gebondeten Substrats nach einem beliebigen der Ansprüche 1 bis 4, wobei die Aussparung, die auf der inneren Seite auf der Oberfläche des Aktive-Schicht-Wafers entlang des äußeren peripheren Abschnitts bereitgestellt wird, an einer Position bereitgestellt wird, die 1 bis 2 mm von dem äußeren peripheren Abschnitt entfernt ist.

6. Verfahren für die Herstellung eines gebondeten Substrats nach einem beliebigen der Ansprüche 1 bis 5, wobei die Aussparung, die auf der inneren Seite auf der Oberfläche des Aktive-Schicht-Wafers entlang des äußeren peripheren Abschnitts bereitgestellt wird, vor einem Spiegelpolieren des Aktive-Schicht-Wafers bereitgestellt wird, und Spiegelpolieren des Aktive-Schicht-Wafers nachdem die Aussparung bereitgestellt wurde, durchgeführt wird.

7. Verfahren für die Herstellung eines gebondeten Substrats nach einem beliebigen der Ansprüche 1 bis 5, wobei die Aussparung, die auf der inneren Seite der Oberfläche des Aktive-Schicht-Wafers entlang des äußeren peripheren Abschnitts bereitgestellt wird, nach dem Spiegelpolieren des Aktive-Schicht-Wafers bereitgestellt wird.

## Revendications

1. Procédé de fabrication d'un substrat lié où une plaquette à couche active est liée à une plaquette de substrat support, comprenant :
une première étape de fourniture d'une rainure sur un côté intérieur sur une surface de la plaquette à couche active le long d'une partie périphérique externe sur une circonférence entière ;
une deuxième étape de détermination d'une surface où la rainure est formée en tant que surface de liaison et, de liaison de la plaquette à couche active à la plaquette de substrat support ; et
une troisième étape de réduction d'une épaisseur de film de la plaquette à couche active et d'élimination d'une partie non liée sur un côté extérieur de la rainure de la plaquette à couche active, **caractérisée en ce que** la rainure ménagée sur le côté intérieur sur la surface de la plaquette à couche active le long de la partie périphérique externe est usinée à l'aide d'un laser guidé par jet d'eau.

2. Procédé de fabrication d'un substrat lié selon la revendication 1, dans lequel la réduction d'une épaisseur de film de la plaquette à couche active est réalisée par meulage d'une surface arrière de la plaquette à couche active jusqu'à atteindre une partie de rainure à partir de la surface.

3. Procédé de fabrication d'un substrat lié selon la revendication 1, dans lequel la réduction d'une épaisseur de film de la plaquette à couche active est effectuée en fournissant préalablement une couche à ions implantés à une profondeur qui ne dépasse pas la partie de rainure à partir de la surface de liaison de la plaquette à couche active sur la base d'une implantation d'ions avant la première étape ou la deuxième étape et d'une délamination de la plaquette à couche active au niveau de la couche à ions implantés sur la base d'un traitement thermique de délamination à la troisième étape.

4. Procédé de fabrication d'un substrat lié selon l'une quelconque des revendications 1 à 3, dans lequel la liaison de la plaquette à couche active et de la plaquette de substrat support est effectuée par un film d'oxyde formé sur l'une des surfaces ou sur les deux surfaces.

5. Procédé de fabrication d'un substrat lié selon l'une quelconque des revendications 1 à 4, dans lequel la rainure ménagée sur le côté intérieur sur la surface de la plaquette à couche active le long de la partie périphérique externe est ménagée au niveau d'une position qui est de 1 à 2 mm en dehors de la partie périphérique externe.

6. Procédé de fabrication d'un substrat lié selon l'une quelconque des revendications 1 à 5, dans lequel la rainure ménagée sur le côté intérieur sur la surface de la plaquette à couche active le long de la partie périphérique externe est ménagée avant un polissage miroir de la plaquette à couche active, et le polissage miroir de la plaquette à couche active est effectué après que la rainure soit ménagée.

7. Procédé de fabrication d'un substrat lié selon l'une quelconque des revendications 1 à 5, dans lequel la rainure ménagée sur le côté intérieur sur la surface de la plaquette à couche active le long de la partie périphérique externe est ménagée après polissage miroir de la plaquette à couche active.
